# EUROPÄISCHE PATENTSCHRIFT

(11) **EP 1 036 207 B1**
(45) Veröffentlichungstag und Bekanntmachung des Hinweises auf die Patenterteilung: **12.09.2001**
(21) Anmeldenummer: 98965093.2
(22) Anmeldetag: 24.11.1998
(51) Int. Cl.: C23C 14/02

(54) **EINRICHTUNG ZUR BEHANDLUNG VON WERKSTÜCKEN IN EINEM NIEDERDRUCK-PLASMA**
DEVICE FOR PROCESSING WORKPIECES IN LOW PRESSURED PLASMA
DISPOSITIF DE TRAITEMENT DE PIECES DANS UN PLASMA BASSE PRESSION

(30) Priorität: 03.12.1997 DE 19753684
(43) Veröffentlichungstag der Anmeldung: 20.09.2000
(73) Patentinhaber: Fraunhofer-Gesellschaft zur Förderung der angewandten Forschung e.V., 80636 München (DE)
(72) Erfinder: WINKLER, Torsten, D-01454 Radeberg (DE); GOEDICKE, Klaus, D-01307 Dresden (DE); FIETZKE, Fred, D-01127 Dresden (DE); SCHILLER, Siegfried, D-01324 Dresden (DE); KIRCHHOFF, Volker, D-01324 Dresden (DE)
(86) Internationale Anmeldenummer: DE9803514
(87) Internationale Veröffentlichungsnummer: WO9928520

(56) Entgegenhaltungen:
- EP-A- 0 535 568
- EP-A- 0 780 485
- DD-A- 136 047
- SCHILLER S ET AL: "VORBEHANDLUNG - BESCHICHTEN - NACHBEHANDLUNG" TECHNISCHE RUNDSCHAU, Bd. 89, Nr. 3, 17. Januar 1997, Seiten 32-34, XP000681098

## Beschreibung

Die Erfindung bezieht sich auf eine Einrichtung zur Behandlung von Werkstücken in einem Niederdruck-Plasma. Es handelt sich dabei vorzugsweise um Werkstücke in Form von Platten, Bändern oder Formteilen, die zum Zwecke der Plasmabehandlung durch das Plasma bewegt werden. Die Art der Bewegung ist der Form der zu behandelnden Werkstücke angepasst. Für Flachprodukte wie Folien oder Tafeln ist im Allgemeinen ein Lineartransport der Werkstücke zweckmäßig, während dreidimensional ausgedehnte Werkstücke vorzugsweise auf rotierenden Halterungen, z.B. in einem Drehkorb, durch das Plasma transportiert werden. Die Einrichtung zur Erzeugung des Niederdruck-Plasmas steht meist in Verbindung mit einer Vakuumanlage. Die Plasma-Behandlung dient der Reinigung, der Aktivierung, der Ätzung, der plasmachemischen Modifizierung oder einer anderen Form der Plasma-Oberflächenbehandlung, oft in Kombination mit einem anschließenden Beschichtungsprozess.

Die Oberflächenbeschichtung mittels physikalischer oder chemischer Dampfphasenabscheidung erfordert fast ausnahmslos eine vorherige Plasma-Behandlung der Werkstückoberflächen. Auch für das Auftragen organischer Beschichtungen, z.B. das Verkleben, Auftragen von Lackierungen, Hydrophobieren oder Hydrophylieren, ist häufig eine Behandlung von Werkstückoberflächen in einem Niederdruck-Plasma erforderlich.

Seit langem sind zahlreiche Einrichtungen zur Erzeugung von Glimmentladungen für die Behandlung von Werkstücken im Plasma bekannt. Sie nutzen selbständige Gasentladungen in einem Edelgas oder einem Gasgemisch, welches auch andere Gase wie Sauerstoff, Wasserstoff oder Kohlenwasserstoffe enthält. Im Wesentlichen beruht die Wirkung des Plasmas darauf, dass das Werkstück als Katode geschaltet ist und von lonen des Plasmas getroffen wird. Nachteilig wirkt bei allen Einrichtungen, die nach dem Prinzip der Dioden-Entladungen arbeiten, dass die Stromdichte und damit die Behandlungsgeschwindigkeit, z.B. der Ätzrate, begrenzt sind. Ein weiterer Nachteil ist der erforderliche vergleichsweise hohe Gasdruck oberhalb von 1 Pa, der für die Aufrechterhaltung dieser Art der Entladungen erforderlich ist. Bei Drücken in diesem Bereich wird durch die Wirkung des Gases ein nennenswerter Teil der beabsichtigten Wirkungen wieder kompensiert oder durch Nebeneffekte gestört.
Aus diesem Grund ist es bekannt, Einrichtungen zur Plasmabehandlung von Werkstücken einzusetzten, die eine Erhöhung der Plasmadichte durch Magnetfelder nutzen. Solche magnetfeldverstärkten Niederdruck-Entladungen zeichnen sich durch eine höhere Bearbeitungsrate, z.B. höhere Ätzrate, aus und arbeiten teilweise auch bei niedrigeren Drücken im Bereich von 0,3...1 Pa.

Weiterhin ist eine Einrichtung zur magnetfeldverstärkten Vorbehandlung von Werkstücken aus bandförmigem Material bekannt, bei der das Werkstück als Katode einer Gleichstromentladung geschaltet ist und bei der das Magnetfeld einer speziellen, als Magnetron bekannten Magnetanordnung das Werkstück durchdringt, so dass sich auf der zu behandelnden Oberfläche des Werkstückes eine ringförmig geschlossene Zone hoher Plasmadichte bildet. Derartige Einrichtungen zeichnen sich durch eine hohe Ätzrate aus und arbeiten in einem optimalen Druckbereich. Ihr Einsatz ist aber auf elektrisch leitende Werkstücke beschränkt. Wesentliche Nachteile ergeben sich jedoch, wenn die zu behandelnden Werkstücke ferromagnetisch sind oder die Dicke der Werkstücke zu groß ist, so dass das Magnetfeld der rückseitig angeordneten Magnetron-Anordnung das Werkstück nicht ausreichend durchdringen kann. In diesen Fällen bildet sich entweder nur eine sehr stromschwache Entladung aus, oder die Einrichtung arbeitet nicht. Im Falle ferromagnetischer Werkstücke treten weiterhin infolge des geringen Abstandes zwischen Magnetron-Anordnung und Werkstück starke magnetische Anziehungskräfte auf, die zu erheblichen technischen Problemen, z.B. zum Verformen bandförmiger Werkstücke, führen können. Für flache Werkstücke, die in Rahmen oder Aufnahmen gehaltert werden müssen, entstehen außerdem geometrisch bedingte Schwierigkeiten, die es nur schwer oder überhaupt nicht ermöglichen, die Magnetron-Anordnung in dem erforderlichen geringen Abstand hinter dem Werkstück anzuordnen. Deshalb lässt sich diese Einrichtung in zahlreichen technisch wichtigen Anwendungsbereichen nicht nutzen.

Es ist weiterhin ein Verfahren und eine Einrichtung zur Plasma-Behandlung von elektrisch leitenden und nicht leitenden Werkstücken unter Nutzung von Wechselstrom-Entladungen im Zusammenhang mit einem PVD-Vakuumbeschichtungsprozess bekannt. Der Werkstückoberfläche gegenüber ist eine Gegenelektrode aus dem Material angeordnet, das für eine an die Plasmabehandlung anschließende Beschichtung durch Magnetron-Zerstäuben vorgesehen ist. Unter der Wirkung des elektrischen Wechselfeldes wird die Werkstückoberfläche im Rhythmus des Polwechsels von Elektronen und Ionen des Fremdmaterials beaufschlagt (DE 195 46 826). Das Verfahren ermöglicht eine gute Haftfestigkeit der aufgestäubten Schicht. In vielen Anwendungsfällen ist jedoch die Beaufschlagung der Werkstückoberfläche mit Fremdmaterial unzulässig, so dass diese Einrichtung auch nicht allgemein anwendbar ist. Nachteilig ist weiterhin eine begrenzte Stromdichte und damit häufig eine zu geringe Wirkungsrate, z.B. Ätzrate, der Plasmabehandlung.

Aufgabe der vorliegenden Erfindung ist die Schaffung einer Einrichtung zur Behandlung von Werkstücken in einem Niederdruckplasma, die die Nachteile und Grenzen des Standes der Technik überwindet. Die Einrichtung soll eine hohe Rate der Plasmabehandlung, z.B. eine hohe Abtragrate und eine intensive Aktivierung der Oberfläche bei einer Ätzung der Werkstücke, ermöglichen. Die Einrichtung soll so beschaffen sein, dass sich praktisch keine Einschränkung für die Form, Materialdicke und Materialart der zu behandelnden Werkstücke ergibt. Zur Erzielung einer hohen Wirksamkeit des mit der Einrichtung auszuübenden Verfahrens soll diese auch bei Gasdrücken unter 1 Pa funktionsfähig sein. Die Einrichtung soll durch Verwendung an sich bekannter Baugruppen geringen apparativen Aufwand erfordern und mit bekannten Vakuumbeschichtungsanlagen kombinierbar sein.

Die erfindungsgemäße Einrichtung ist durch die Merkmale des Anspruches 1 gekennzeichnet. Zweckmäßige Ausgestaltungen sind in den Ansprüchen 2 bis 17 beschrieben.

Durch die erfindungsgemäße Einrichtung erfolgt eine intensive Behandlung jeweils eines Bereiches der Oberfläche des Werkstückes. Es gehört deshalb zum Wesen der Erfindung, dass der Transport des Werkstückes bzw. der Werkstücke so gestaltet ist, dass die gesamte zu behandelnde Oberfläche des Werkstückes oder alle zu behandelnden Bereiche der Oberfläche nacheinander durch die Bereiche hoher Plasmadichte geführt werden. Wesentlich ist, dass bei der erfindungsgemäßen Einrichtung im Gegensatz zu bekannten Einrichtungen nur auf der der zu behandelnden Oberfläche gegenüberliegenden Seite magnetfelderzeugende Einrichtungen angeordnet sind und dass diese Einrichtungen einen Abstand von mindestens 30 mm zu der zu behandelnden Oberfläche aufweisen. Dadurch besteht die Möglichkeit, die Werkstücke in zweckmäßig gestalteten Halterungen oder Rahmen aufzunehmen. Diese Halterungen, Rahmen oder Dreh- und Bewegungseinrichtungen für die Werkstücke können z.B. mit nach mehreren Seiten überstehenden Teilen versehen sein, was für ihre zweckmäßige Gestaltung und ihre Funktion in vielen Anwendungsfällen von großer Bedeutung ist.

Sind die zu behandelnden Werkstücke aus ferromagnetischem Material, z.B. aus Eisenwerkstoffen, so treten nur solche Deformationen und Veränderungen des Magnetfeldes der magnetfelderzeugenden Einrichtung auf, die die Ausbildung einer stromstarken Niederdruck-Plasmaentladung nicht stören. Auch magnetische Anziehungskräfte zwischen ferromagnetischen Werkstücken und den magnetfelderzeugenden Einrichtungen sind von geringer Wirkung und beeinträchtigen nicht die Funktion der Einrichtung.

Die charakteristische Art der Stromversorgung und der Potentialverhältnisse begründen, dass die Niederdruckentladung stabil arbeitet und im Allgemeinen nicht in eine Bogenentladung umschlägt. Selbst wenn ein solcher Umschlag in eine Bogenentladung gelegentlich stattfinden sollte, so wird nur ein geringer Energiebetrag, der maximal dem Energieinhalt eines Strompulses entspricht, als Bogenstrom auf dem Werkstück wirksam. Der folgende Strompuls fließt wieder in Form einer magnetfeldverstärkten Niederdruck-Plasmaentladung durch das Werkstück. Auf diese Weise wird eine fehlerfreie gleichmäßige Plasmabehandlung der Werkstückoberfläche erreicht.

In Bezug auf die Impedanz und die elektrischen Kennwerte wird mit der Einrichtung ein Typ einer Niederdruckentladung erzeugt, der in seinen Eigenschaften eine Mittelstellung zwischen den bekannten Dioden-Glimmentladungen und den bekannten Magnetron-Entladungen einnimmt. Die gegenüber der Magnetronentladung höhere und zeitabhängige Brennspannung ist mit einem breiteren Energiespektrum der auf die Werkstücke auftreffenden lonen verbunden. Dadurch ist auch die Palette der durch die Plasmabehandlung erreichbaren Elementarwirkungen breiter.

Da mit der erfindungsgemäßen Einrichtung auch sehr stromstarke Niederdruck-Entladungen betrieben werden können, ist es zweckmäßig, die Gegenelektroden zu kühlen, indem vorzugsweise eine Wasserkühlung angewendet wird.

Bei intensiver Plasmabehandlung erfolgt entsprechend der Zielsetzung ein Abtrag von Material der Werkstückoberfläche. Es ist zweckmäßig, die magnetfelderzeugenden Einrichtungen mit Auffängern für die Kondensation dieses abgetragenen Materials auszustatten. Auch diese Auffänger sind vorteilhafterweise gekühlt. Um mit den Auffängern sehr viel Material aufnehmen zu können und damit eine lange wartungsfreie Betriebszeit der Einrichtung zu erreichen, ohne dass störende Partikelbildung eintritt, haben die Auffänger eine extrem rauhe Oberfläche.

Die magnetfelderzeugende Einrichtung ist in ihrer lateralen Gestaltung so gestaltet, dass sich zusammen mit der Transportrichtung des Werkstückes eine hohe Gleichmäßigkeit der Plasmabehandlung auf der Werkstückoberfläche ergibt. Im Interesse der Erhöhung der Wirkungsrate und einer Verringerung der elektrischen Impedanz der Niederdruckentladung ist es vorteilhaft, mehrere gleichartige magnetfelderzeugende Einrichtungen nebeneinander und gegenüber der zu behandelnden Oberfläche oder Bereiche der Oberfläche des Werkstückes anzuordnen.

Für die gleichzeitige Plasmabehandlung der Vorderseite und der Rückseite flacher Werkstücke ist es zweckmäßig, gegenüber der Vorderseite und der Rückseite des Werkstückes in besagtem Abstand magnetfelderzeugende Einrichtungen und Gegenelektroden anzuordnen. Dabei kann die Stromversorgungseinrichtung zwischen das Werkstück und mehrere elektrisch leitend verbundene Gegenelektroden geschaltet sein. Im Interesse einer gleich intensiven Plasmabehandlung verschiedener Bereiche der Werkstückoberfläche, beispielsweise der Vorderseite und der Rückseite, werden vorteilhafterweise die Teilströme zu den einzelnen Gegenelektroden einzeln gemessen. Dadurch ist es möglich, die Einrichtung mit Mitteln auszustatten, die eine Beeinflussung der einzelnen Entladungsströme, z.B. ihre Angleichung, vornehmen.

Das Magnetfeld der magnetfelderzeugenden Einrichtung erzeugen Permanentmagnete; vorzugsweise bestehen diese aus Verbindungen seltener Erdmetalle. Sie sind zweckmäßig in ihrem Abstand zur Werkstückoberfläche verstellbar. Es ist besonders vorteilhaft, wenn diese Verstellung durch Vorrichtungen außerhalb der Vakuumkammer vorgenommen wird. Es ist auch möglich, die magnetfelderzeugenden Einrichtungen mittels elektromagnetischer Spulen aufzubauen und mit bekannten Mitteln einen vorgegebenen Spulenstrom auszurüsten. Es ist besonders vorteilhaft, den Spulenstrom für unterschiedliche magnetfelderzeugende Einrichtungen so einzustellen oder zu regeln, dass ein bestimmtes Verhältnis der Entladungsströme, die an den einzelnen Gegenelektroden gemessen werden, erreicht wird, z.B. die Gleichheit der Ströme.
Eine weitere Ausgestaltung der Einrichtung besteht darin, den Raum zwischen den Bereichen der zu behandelnden Werkstückoberfläche und den magnetfelderzeugenden Einrichtungen mit Ausnahme von schmalen Spalten durch Blenden zu begrenzen und mit Mitteln zur Zuführung von Arbeitsgas zu versehen, so dass ein erhöhter Arbeitsgasdruck im Bereich der magnetfeldverstärkten Niederdruck-Entladungen eingestellt werden kann. Durch Einstellung unterschiedlicher Werte des Arbeitsgasdruckes kann der Strom zu den einzelnen Gegenelektroden auf einen bestimmten Wert bzw. ein bestimmtes vorgegebenes Verhältnis eingestellt werden.

Es ist auch vorteilhaft, zwischen das Werkstück und je eine Gegenelektrode je eine Stromversorgungseinrichtung zu schalten, wobei die Synchronisation der gepulsten Ströme zweckmäßig ist. Damit kann der Strom zu den einzelnen Gegenelektroden auf vorgegebene Werte eingestellt werden.

Die Gegenelektrode bzw. die Gegenelektroden werden außerhalb des Magnetfeldes der magnetfelderzeugenden Einrichtung, d.h. in großem Abstand vom Bereich hoher Plasmadichte angeordnet. Damit befinden sie sich außerhalb des Stromes des von der Werkstückoberfiäche abgetragenen Materials. Es kann darüber hinaus zweckmäßig sein, die Gegenelektroden mit Abschirmblechen zu versehen, um ihre Bedeckung mit Teilen des vom Werkstück abgetragenen Materials weiter zu verringern.

Die Erfindung soll an einem Ausführungsbeispiel erläutert werden.

Die zugehörige Zeichnung zeigt eine Einrichtung zur Behandlung von Stahlblechen als Draufsicht. Die Werkstücke (im Folgenden als Werkstück bezeichnet) hoher Oberflächengüte sollen zum Zweck einer anschließenden Vakuumbeschichtung in einem Niederdruck-Plasma von Fremdschichten, insbesondere dünnen Ölschichten, Wasser und oxidischen Verunreinigungen befreit werden. Dabei ist eine schonende gleichmäßige Behandlung der Vorder- und Rückseite der Werkstücke angestrebt. Kraterbildung und Markierungen, die sich durch lokale Bogenentladungen bei einer Plasmabehandlung mit bekannten Einrichtungen nicht vermeiden lassen, sind zu verhindern. Die zu behandelnden Werkstücke haben eine Abmessung von 500 mm × 500 mm und eine Dicke von 2 mm. Zum Zweck der Plasmabehandlung werden die Werkstücke in bekannter Weise durch eine Vakuumschleuse in eine Vakuumkammer mit den Abmessungen 1,6 m × 1 m × 0,3 m eingebracht und mit einer Transportgeschwindigkeit von 0,2 m/min auf einer bekannten Transportbahn senkrecht stehend in Längsrichtung durch die Vakuumkammer transportiert. Durch eine weitere Vakuumschleuse, die auf der der Eingangsschleuse entgegengesetzten Seite der Vakuumkammer angeordnet ist, werden die Werkstücke wieder ausgebracht. Die Vakuumkammer und Vakuumschleusen sind mit bekannten Vakuumpumpen, Ventilen, Mitteln zum Gaseinlass, zur Druckmessung und -regelung sowie mit Steuerorganen ausgestattet.

Zur Plasmabehandlung und zum Transport befinden sich die Werkstücke 1 in einem Rahmen 2 aus Stahlprofil, der an der Ober- und Unterseite einen 100 mm breiten Blechstreifen trägt (nicht gezeichnet), welcher fest mit dem Rahmen 2 verbunden ist. In der Vakuumkammer 3 sind zwei magnetfelderzeugende Einrichtungen 4 nach Art eines Magnetrons angeordnet. Ihre Längsausdehnung ist senkrecht zur Transportrichtung. Sie bestehen aus jeweils einer ferromagnetischen Rückschlussplatte 5 und Samarium-Kobalt-Permanentmagneten. Die Magnete 6 bilden quer zur Transportrichtung jeweils zwei geradlinige parallele Spaltfelder 7, die bogenförmig an den Rändern im Bereich der Blechstreifen der Rahmen 2 verbunden sind. Auf diese Weise entstehen ringförmig geschlossene Bereiche hoher Magnetfeldstärke. Der Abstand zwischen den Werkstücken 1 und den Magneten 6 beträgt 50 mm. Durch Hubspindeln (nicht gezeichnet), die mittels Durchführungen über Bedienelemente außerhalb des Vakuums ansteuerbar sind, kann dieser Abstand auf maximal 60 mm erhöht werden.

Auf der dem Werkstück 1 zugewandten Seite tragen die magnetfelderzeugenden Einrichtungen 4 jeweils ein gekühltes Blech als Auffänger 8, welches mit einem siebartigen Metallgitter zur Vergrößerung der Oberfläche versehen ist. Am Ende der Transportbahn (nicht gezeichnet) innerhalb der Vakuumkammer 3 befinden sich beidseitig der Werkstücke 1 in einem Abstand von 100 mm zwei Gegenelektroden 9 aus gekühltem Kupferrohr. Die Transportbahn, magnetfelderzeugenden Einrichtungen 4, Auffänger 8 und Gegenelektroden 9 sind untereinander und gegen die Vakuumkammer 3 elektrisch isoliert. Ein Sinusgenerator 10 als Stromversorgungseinrichtung, der gegen Erde elektrisch isoliert ist, ist zwischen einen Schleifkontakt 11 an dem Rahmen 2 und die untereinander elektrisch leitend verbundenen Gegenelektroden 9 geschaltet.

In der Vakuumkammer 3 ist ein Gasdruck von 0,8 Pa eingestellt. Das Arbeitsgas besteht aus Argon mit einem Anteil von 2 Prozent Wasserstoff. Wenn der Sinusgenerator 10 eine Spannung mit einem Effektivwert von 1600 V erzeugt und das im Transportrahmen 2 befindliche Werkstück 1 in den Bereich der magnetfelderzeugenden Einrichtung 4 gelangt, zündet eine stromstarke magnetfeldverstärkte Niederdruckentladung auf beiden Seiten des zu behandelnden Werkstückes 1. Mittels bekannter Strommesszangen kann der durch jede der Gegenelektroden 9 fließende Strom gemessen werden. Die Effektivwerte liegen bei etwa 5 A. Durch Veränderung des Abstandes einer der magnetfelderzeugenden Einrichtungen 4 zum Werkstück 1 wird eine Anpassung der Impedanz der Entladungen auf der Vorderseite und der Rückseite des Werkstückes 1 vorgenommen, so dass beide Ströme gleich groß sind. Die Frequenz des Sinusgenerators 10 hängt von der Impedanz selbst ab und liegt im Bereich von etwa 15 kHz. Unter der Wirkung der Plasmabehandlung werden beide Seiten des Werkstückes 1 homogen mit Ionen, angeregten und neutralen Spezies des Plasmas sowie mit Strahlung beaufschlagt und dabei alle Fremdschichten sowie eine dünne Oberflächenschicht des Materials des Werkstückes 1 selbst abgetragen. Inhomogenitäten des Abtrages sind nur im Bereich der ungenutzten Blechstreifen des Transportrahmens 2 nachweisbar. Die Oberfläche des auf diese Weise im Plasma behandelten Werkstückes 1 weist sehr gleichmäßige Oberflächentopographie auf und ist hoch aktiviert, so dass eine sehr gute Haftfestigkeit einer anschließend aufgebrachten organischen Beschichtung erreicht wird.

Die magnetfelderzeugende Einrichtung 4 ist von Blenden 13 umgeben. Innerhalb dieser sind Düsen 12 für den Gaseinlass vorgesehen. Die Gegenelektroden 9 sind durch Abschirmbleche 14 geschützt.

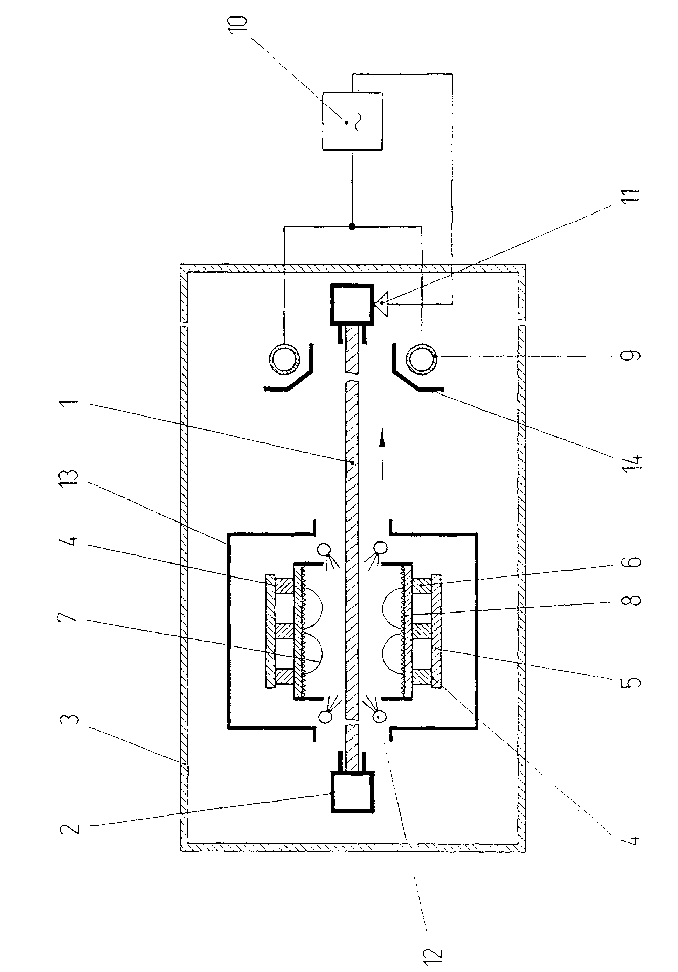

## Patentansprüche

1. Einrichtung zur Behandlung von Werkstücken in einem Niederdruck-Plasma, das magnetfeldverstärkt ist, bestehend aus einer Vakuumkammer, Einrichtungen zur Erzeugung eines vorgegebenen Druckes eines Arbeitsgases, Mitteln zum Transport von Werkstücken in die Vakuumkammer durch den Plasmabereich im Inneren der Vakuumkammer und aus der Vakuumkammer sowie Steuer- und Regeleinrichtungen,
**dadurch gekennzeichnet,**
- dass die Mittel zum Transport der Werkstücke (1) so ausgebildet sind, dass die gesamte zu behandelnde Oberfläche des Werkstückes (1) oder mehrere Bereiche der Oberfläche nacheinander durch den Plasmabereich bewegbar sind,
- dass das Werkstück (1) als eine Elektrode der Niederdruck-Entladung geschaltet ist,
- dass mindestens eine magnetfelderzeugende Einrichtung (4) nach Art einer Magnetron-Anordnung, die elektrisch isoliert ist, in einem Abstand von 30...100 mm gegenüber der Oberfläche des zu behandelnden Werkstückes (1) angeordnet ist,
- dass mindestens eine Gegenelektrode (9) außerhalb des vom Magnetfeld erfüllten Raumes angeordnet ist,
- dass an das Werkstück (1) und die Gegenelektroden (9) je ein Pol einer Stromversorgungseinrichtung, die einen gepulsten Strom erzeugt, angeschlossen ist.

2. Einrichtung nach Anspruch 1, **dadurch gekennzeichnet, dass** an das Werkstück (1) und die Gegenelektrode (9) vorzugsweise eine Wechselstromquelle, deren erzeugter Strom eine Frequenz von 10 Hz bis 200 kHz erzeugt, angeschlossen ist.

3. Einrichtung nach Anspruch 1 und 2, **dadurch gekennzeichnet, dass** die Gegenelektroden (9) gekühlt, vorzugsweise wassergekühlt sind.

4. Einrichtung nach mindestens einem der vorherigen Ansprüche, **dadurch gekennzeichnet, dass** mit der magnetfelderzeugenden Einrichtung (4) in Richtung zu der zu behandelnden Oberfläche des Werkstückes (1) mindestens ein Auffänger (8) für das von der Oberfläche abgetragene Material angeordnet ist.

5. Einrichtung nach Anspruch 4, **dadurch gekennzeichnet, dass** der Auffänger (8) gekühlt ist.

6. Einrichtung nach Anspruch 4 und 5, **dadurch gekennzeichnet, dass** die Oberfläche des Auffängers (8) extrem rauh ist.

7. Einrichtung nach mindestens einem der vorherigen Ansprüche, **dadurch gekennzeichnet, dass** mehrere magnetfelderzeugende Einrichtungen (4) nebeneinander und gegenüber der zu behandelnden Oberfläche des Werkstückes (1) angeordnet sind.

8. Einrichtung nach mindestens einem der vorherigen Ansprüche, **dadurch gekennzeichnet, dass** gegenüber mehreren zu behandelnden Bereichen der Oberfläche des Werkstückes (1), die einander gegenüber liegen oder einen Winkel zueinander bilden, jeweils mindestens eine magnetfelderzeugende Einrichtung (4) angeordnet ist.

9. Einrichtung nach mindestens einem der vorherigen Ansprüche, **dadurch gekennzeichnet, dass** zur Erzeugung des Magnetfeldes in den magnetfelderzeugenden Einrichtungen (4) Permanentmagnete (6), vorzugsweise aus Verbindungen seltener Erdmetalle, angeordnet sind.

10. Einrichtung nach Anspruch 9, **dadurch gekennzeichnet, dass** die magnetfelderzeugenden Einrichtungen (4) in ihrem Abstand zur Oberfläche des zu behandelnden Werkstückes (1) ohne Unterbrechung des Vakuums veränderbar sind.

11. Einrichtung nach mindestens einem der vorherigen Ansprüche, **dadurch gekennzeichnet, dass** zur Erzeugung des Magnetfeldes in den magnetfelderzeugenden Einrichtungen (4) Elektromagnete (6) angeordnet sind.

12. Einrichtung nach Anspruch 11, **dadurch gekennzeichnet, dass** die Magnetfeldstärke auf der Oberfläche des zu behandelnden Werkstückes (1) mit elektrischen Mitteln, vorzugsweise durch Veränderung des Spulenstromes der Elektromagnete (6), auf einen vorgegebenen Wert einstellbar ist.

13. Einrichtung nach mindestens einem der vorherigen Ansprüche, **dadurch gekennzeichnet, dass** die magnetfelderzeugenden Einrichtungen (4) so gepolt sind, dass sich die Magnetfelder der magnetfelderzeugenden Einrichtungen (4) durch Superposition in ihrer Gesamtwirkung nahe der Oberfläche des zu behandelnden Werkstückes (1) verstärken.

14. Einrichtung nach mindestens einem der vorherigen Ansprüche, **dadurch gekennzeichnet, dass** Blenden die Bereiche zwischen den magnetfelderzeugenden Einrichtungen (4) und den zu behandelnden Bereichen der Oberfläche des Werkstückes (1) begrenzend und Mittel zur Zuführung des Arbeitsgases derart angeordnet sind, dass sich gegenüber der übrigen Vakuumkammer (3) ein Bereich höheren und einstellbaren Gasdruckes, eine sogenannte Druckstufe, entsteht.

15. Einrichtung nach mindestens einem der vorherigen Ansprüche, **dadurch gekennzeichnet, dass** die Stromversorgungseinrichtung zwischen das zu behandelnde Werkstück (1) und mehrere miteinander elektrisch leitend verbundene Gegenelektroden (9) geschaltet ist.

16. Einrichtung nach mindestens einem der vorherigen Ansprüche, **dadurch gekennzeichnet, dass** zwischen das zu behandelnde Werkstück (1) und je eine von mehreren Gegenelektroden (9) jeweils eine Stromversorgungseinrichtung geschaltet ist und dass die Pulsfrequenz der einzelnen Stromversorgungseinrichtungen synchronisiert ist.

17. Einrichtung nach mindestens einem der vorherigen Ansprüche, **dadurch gekennzeichnet, dass** die Gegenelektroden (9) derart angeordnet und von Abschirmblechen (14) umgeben sind, dass das von der Oberfläche des zu behandelnden Werkstückes (1) abgetragene Material nicht auf die Gegenelektroden (9) trifft.

## Claims

1. Apparatus for treating workpieces in a low pressure plasma, which is amplified by a magnetic field, consisting of a vacuum chamber, devices for creating a predetermined pressure of a working gas, means for transporting workpieces into the vacuum chamber, through the plasma region in the interior of the vacuum chamber and out of the vacuum chamber, as well as control and regulating devices, **characterized in that**
- the means for transporting the workpieces (1) are so designed that the whole surface to be treated of the workpiece (1) or several regions of the surface can be moved through the plasma region in succession,
- in that the workpiece (1) is connected as an electrode of the low pressure discharge,
- in that at least one device (4) creating a magnetic field of the nature of a magnetron arrangement, which is electrically isolated, is arranged spaced 30 to 100 mm relative to the surface of the workpiece (1) to be treated,
- in that at least one counter-electrode (9) is arranged outside the space occupied by the magnetic field,
- in that the workpiece (1) and the counter-electrode (9) are each connected to one pole of a current supply device which generates a pulsed current.

2. Apparatus according to claim 1, **characterized in that** there is preferably connected to the workpiece (1) and the counter-electrode (9) an alternating current source whose generated current produces a frequency of 10 Hz to 200 kHz.

3. Apparatus according to claim 1 or 2, **characterized in that** the counter-electrode (9) is cooled, preferably water cooled.

4. Apparatus according to at least one of the preceding claims, **characterized in that** at least one trap (8) for material eroded from the surface is arranged in the direction of the surface of the workpiece (1) to be treated with the device (4) creating the magnetic field.

5. Apparatus according to claim 4, **characterized in that** the trap (8) is cooled.

6. Apparatus according to claim 4 or 5, **characterized in that** the surface of the trap (8) is extremely rough.

7. Apparatus according to at least one of the preceding claims, **characterized in that** a plurality of devices (4) creating a magnetic field are arranged beside one another and opposite the surface to be treated of the workpiece (1).

8. Apparatus according to at least one of the preceding claims, **characterized in that** at least one device (4) creating a magnetic field is arranged opposite each of a plurality of regions of the surface of the workpiece (1) to be treated which lie opposite one another or form an angle with one another.

9. Apparatus according to at least one of the preceding claims, **characterized in that** permanent magnets (6), preferably of compounds of rare earth metals, are arranged in the devices (4) creating a magnetic field for creating the magnetic field.

10. Apparatus according to claim 9, **characterized in that** the devices (4) creating a magnetic field can have their spacing from the surface of the workpiece (1) to be treated varied, without breaking the vacuum.

11. Apparatus according to at least one of the preceding claims, **characterized in that** electromagnets (6) are arranged in the devices (4) creating a magnetic field for creating the magnetic field.

12. Apparatus according to claim 11, **characterized in that** the magnetic field strength at the surface of the workpiece (1) to be treated can adjusted to a predetermined value by electrical means, preferably by altering the coil current of the electromagnets (6).

13. Apparatus according to at least one of the preceding claims, **characterized in that** the devices (4) creating a magnetic field are so poled that the magnetic fields of the devices (4) creating a magnetic field are amplified by superposition in their overall action near to the surface of the workpiece (1) to be treated.

14. Apparatus according to at least one of the preceding claims, **characterized in that** screens which delimit the regions between the devices (4) creating a magnetic field and the regions of the surface of the workpiece (1) to be treated and means for supplying the working gas are so arranged that a region of higher and adjustable gas pressure compared with the rest of the vacuum chamber - a so-called pressure step - results.

15. Apparatus according to at least one of the preceding claims, **characterized in that** the current supply device is connected between the workpiece (1) to be treated and a plurality of counter-electrodes (9) connected electrically conductively together.

16. Apparatus according to at least one of the preceding claims, **characterized in that** a respective current supply device is connected between the workpiece (1) to be treated and each of a plurality of counter-electrodes (9) and in that the pulse frequencies of the individual current supply devices are synchronised.

17. Apparatus according to at least one of the preceding claims, **characterized in that** the counter-electrodes (9) are so arranged and surrounded by shield plates (14) that material eroded from the surface of the workpiece (1) to be treated does not impinge on the counter-electrodes (9).

## Revendications

1. Installation de traitement de pièces par un plasma basse pression amplifié par un champ magnétique, comprenant une chambre à mde, des installations générant la pression de gaz de travail prédéterminée, des moyens pour transporter les pièces dans la chambre à vide à travers la zone du plasma à l'intérieur de la chambre à vide et pour les en extraire ainsi que des installations de commande et de régulation,
**caractérisée par**
- des moyens pour le transport de la pièce (1) réalisés pour permettre de déplacer l'ensemble de la surface à traiter de la pièce (1) ou plusieurs zones de cette surface, successivement dans la zone du plasma,
- la pièce (1) est branchée comme élechode de décharge basse pression,
- au moins une installation (4) générant un champ magnétique du type magnétron est isolée électriquement à une distance de 30-100 mm par rapport à la surface de la pièce (1) à traiter.
- au moins une contre-électrode (9) est prévue à l'extérieur de l'enceinte du champ magnétique,
- la pièce (1) et la contre-électrode (9) sont reliées respectivement à un pôlc d'une installation d'alimentation électrique générant un courant pulsé.

2. Installation selon la revendication 1,
**caractérisée en ce que**
la pièce (1) et la contre-électrode (9) sont reliées de préférence à une source de courant alternatif dont le courant est à une fréquence de l'ordre de 10 Hz jusqu'à 200 kHz.

3. Installation selon l'une quelconque des revendications 1 et 2,
**caractérisée en ce que**
les contre-électrodes (9) sont refroidies de préférence à l'eau.

4. Installation selon l'une quelconque des revendications précédentes,
**caractérisée en ce qu'**
en direction de la surface de la pièce (1) à traiter, l'installation (4) générant un champ magnétique comporte au moins un récepteur (8) pour recevoir la matière à enlever de la surface de la pièce.

5. Installation selon la revendication 4,
**caractérisée en ce que**
le récepteur (8) est refroidi.

6. Installation selon l'une quelconque des revendications 4 et 5,
**caractérisée en ce que**
la surface du récepteur (8) est extrêmement rugueuse.

7. Installation selon l'une quelconque des revendications précédentes,
**caractérisée par**
plusieurs installations (4) générant un champ magnétique, Juxtaposées et placées en regard de la surface de la pièce (1) à traiter.

8. Installation selon l'une quelconque des revendications précédentes,
**caractérisée en ce que**
vis-à-vis de plusieurs zones à traiter de la surface de la pièce (1), situées en regard ou faisant entre elles un angle, on place chaque fois au moins une installation (4) générant un champ magnétique.

9. Installation selon l'une quelconque des revendications précédentes,
**caractérisée en ce que**
des aimants permanents (6) de préférence sous la forme de combinaisons de métaux terreux rares générent le champ magnétique dans les installations (4).

10. Installation selon la revendication 9,
**caractérisée en ce que**
les installations (4) générant un champ magnétique sont à une distance variable de la surface de la pièce (1) à traiter sans coupure du vide.

11. Installation selon l'une quelconque des revendications précédentes,
**caractérisée en ce que**
des électro-aimants (6) sont placés dans les installations (4) générant le champ magnétique.

12. Installation selon la revendication 11.
**caractérisée en ce que**
l'intensité du champ magnétique à la surface de la pièce (1) à traiter se règle avec des moyens électriques, de préférence en modifiant le courant dans la bobine des électro-aimants (6) à une valeur prédéterminée.

13. Installation selon l'une quelconque des revendications précédentes,
**caractérisée en ce que**
les installations (4) générant le champ magnétique sont polarisées pour quc le champ magnétique qu'elles créent s'amplifie par superposition, dans leur effet global à proximité de la surface de la pièce (1) à traiter.

14. Installation selon l'une quelconque des revendications précédentes,
**caractérisée en ce que**
des diaphragmes sont prévus au voisinage d'installations (4) générant le champ magnétique et par rapport aux zones à traiter de la surface de la pièce (1), ainsi que des moyens pour fournir le gaz de travail, de façon à créer un niveau de pression de gaz réglable et plus élevé que dans les autres parties de la chambre à vide 3.

15. Installation selon l'une quelconque des revendications précédentes,
**caractérisée en ce que**
l'installation d'alimentation électrique est branchée entre la pièce (1) à traiter et plusieurs contre-électrodes (9) reliées en conduction électrique.

16. Installation selon l'une quelconque des revendications précédentes,
**caractérisée en ce qu'**
entre la pièce (1) à traiter et l'une des différentes contre-électrodes (9), on a une installation d'alimentation électrique et la fréquence impulsionnelle des différentes installations d'alimentation électrique est synchronisée.

17. Installation selon l'une quelconque des revendications précédentes,
**caractérisée en ce que**
les contre-électrodes (9) sont disposées et sont entourées de tôles formant écran (14) pour que la matière enlevée de la surface de la pièce à traiter (1) n'arrive pas sur la contre-électrode (9).
